(19) Europäisches Patentamt
European Patent Office
Office européen des brevets

(11) **EP 4 723 158 A1**

(12) **EUROPEAN PATENT APPLICATION**

(43) Date of publication:
08.04.2026 Bulletin 2026/15

(21) Application number: 24204241.4

(22) Date of filing: 02.10.2024

(51) International Patent Classification (IPC):
*H01J 37/147* (2006.01)    *H01J 37/28* (2006.01)
*H01J 37/12* (2006.01)

(52) Cooperative Patent Classification (CPC):
**H01J 37/1471; H01J 37/12; H01J 37/28;**
H01J 2237/0453; H01J 2237/1205;
H01J 2237/1503; H01J 2237/1516; H01J 2237/2817

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicant: ASML Netherlands B.V.
5500 AH Veldhoven (NL)

(72) Inventor: WIELAND, Marco, Jan-Jaco
5500 AH Veldhoven (NL)

(74) Representative: ASML Netherlands B.V.
Corporate Intellectual Property
P.O. Box 324
5500 AH Veldhoven (NL)

(54) **CHARGED PARTICLE-OPTICAL DEVICE AND METHOD OF ASSESSING**

(57)    A charged particle-optical device configured to direct a plurality of charged particle beams along respective beam paths towards a sample surface, the charged particle-optical device comprising:
an objective lens arrangement having a plurality of electrode plates arranged to focus the plurality of charged particle beams onto the sample surface in a grid; and
a deflector array located adjacent one of the plurality of electrode plates, wherein the deflector array is configured to deflect one or more of the plurality of charged particle beams so that at least one of the plurality of charged particle beams has a different pitch with respect to its nearest neighbors.

Fig. 8

**Description**

FIELD

The present invention relates to charged particle optical devices and to methods of assessing samples using such devices.

BACKGROUND

During manufacturing processes of, for example, semiconductor integrated circuit (IC) chips or displays, undesired defects may occur on a substrate (e.g. wafer or a mask). Such defects may reduce yield. Defects may occur as a consequence of all kinds of processing necessary to produce an integrated circuit or display, for example, lithography, etching, deposition or chemical mechanical polishing. Defects may include patterning defects, in which the created pattern lies outside the pattern tolerance for the process, and particles. Monitoring the extent of defects during the manufacturing processes is therefore important. Such monitoring (or more generally assessment) includes the determination of the existence of a defect, but also the classification of the types of defects found.

For the assessment of a sample, different types of inspection or metrology systems have been used, including charged particle systems such as electron microscopes. Such assessment for inspection may relates to defects, for example the existence and classification of such defects. Electron microscopes typically generate a probe beam (also often referred to as primary beam) which may, for example, be scanned across a part of the substrate (such as in a scanning electron microscopes (SEM)). Collecting interaction products that result from the interaction of the primary beam with the part of the substrate, allows the electron microscope to collect data representing the probed part of the substrate. The data may be processed/rendered for example by the electron microscope to generate an image representation of the part of the substrate. The collected data for example as a generated image representation allows for measuring structures on the part of the substrate, or allows for identifying defective structures by comparing the image representation with a reference. Such measurement may be referred to as metrology; the identification of defective structures may be referred to as (defect) inspection. The interaction products may contain charged particles which may be referred to as signal particles (e.g. signal electrons), such as secondary electrons and backscattered electrons, and may contain other interaction products, such as X-ray radiation and even light.

The rate at which a charged particle optical device can scan a sample (e.g. a substrate) is limited by stochastic scattering, which increases if the beam current is increased. To reduce the time taken to assess a sample, multi-beam charged particle-optical devices have been proposed. In a multi-beam charged particle-optical device, a plurality of beams are directed to the sample simultaneously and the sample is scanned underneath the beams. The time taken to assess a sample is thereby reduced by a factor equal to the number of beams.

Another approach to reducing the time taken to assess a sample is to only assess selected areas of interest. For example, assessment may be limited to critical features of a device pattern or to target features that are especially sensitive to imaging errors or defects. If only a small proportion of a sample needs to be assessed, a large increase in throughput (measured in samples per hour) can be achieved.

However, the advantages of a multi-beam charged particle-optical device and of selective assessment cannot be simultaneously achieved, or not fully achieved, if the arrangement of areas to be assessed does not correspond to the arrangement of the plurality of beams, which is fixed in hardware. In such a case, if the sample is positioned so that one area of interest is scanned by one beam, other beams may be scanning areas of no interest and not producing useful data.

SUMMARY

A multi-beam charged particle-optical device having greater flexibility in the arrangement of areas of a sample that can be simultaneously scanned is desirable.

According to an aspect of the invention there is provided a charged particle-optical device configured to direct a plurality of charged particle beams along respective beam paths towards a sample surface, the charged particle-optical device comprising:

an objective lens arrangement having a plurality of electrode plates arranged to focus the plurality of charged particle beams onto the sample surface in a grid; and
a deflector array located adjacent one of the plurality of electrode plates, wherein the deflector array is configured to deflect one or more of the plurality of charged particle beams so that at least one of the plurality of charged particle beams has a different pitch with respect to its nearest neighbors.

According to an aspect of the invention there is provided a method of assessing a sample using an assessment apparatus comprising a charged particle-optical device configured to direct a plurality of charged particle beams onto the sample, the charged particle-optical device having a plurality of electron-optic electrodes; and a deflector array located adjacent the one of the plurality of electron-optic electrodes wherein the deflector array is configured to deflect one or more of the plurality of charged particle beams, the method comprising

energizing the deflector array to deflect one or more of the plurality of charged particle beams so that the at least one of the plurality of charged particle beams has a different pitch with respect to its nearest neighbors.

BRIEF DESCRIPTION OF THE DRAWINGS

Embodiments of the invention will now be described, by way of example only, with reference to the accompanying schematic drawings, in which:

- Figure 1 is a schematic diagram of an exemplary assessment apparatus;
- Figure 2 schematically depicts a multi-beam charged particle-optical device, for example of the assessment apparatus of Figure 1;
- Figure 3 schematically depicts a multi-beam charged particle-optical device, for example of the assessment apparatus of Figure 1;
- Figure 4 schematically depicts an alternative multi-beam charged particle-optical device, for example of the assessment apparatus of Figure 1
- Figure 5 schematically depicts a detector array in plan view;
- Figure 6 schematically depicts an arrangement of beams in a multi-beam charged particle-optical device and corresponding fields of view;
- Figure 7 schematically depicts a multi-beam charged particle-optical device according to an embodiment;
- Figure 8 depicts fields of view and offset ranges of the embodiment of Figure 6;
- Figure 9 schematically depicts a multi-beam charged particle-optical device according to another embodiment;
- Figure 10 schematically depicts a multi-beam charged particle-optical device according to another embodiment;
- Figure 11 depicts fields of view and offset ranges of the embodiment of Figure 8.

The Figures are schematic. Within the following description of drawings, the same or like reference numbers refer to the same or like components or entities, and only the differences with respect to the individual embodiments are described. While the description and drawings are directed to an electron-optical apparatus, it is appreciated that the embodiments are not used to limit the present disclosure to specific charged particles. References to electrons, and items referred to with reference to electrons, throughout the present document may therefore be more generally be considered to be references to charged particles, and items referred to in reference to charged particles, with the charged particles not necessarily being electrons. For example, references to an electron-optical device may more generally be considered to be references to a charged particle-optical device

DETAILED DESCRIPTION

There is a trend in the semiconductor industry (often known as "Moore's law") to reduce the physical dimensions of structures representing circuit components on a substrate and/or to increase the packing density of such structures, in order to reduce the physical size of electronic devices and/or enhance the computing power of electronic devices. The physical dimensions of such structures may be reduced and/or the packing density of such structures may be increased by increasing lithographic resolution. Manufacturing processes of semiconductor IC chips can have 100s of individual steps. An error in any step of the manufacturing process has the potential to adversely affect the functioning of the electronic device. It is desirable to improve the overall yield of the manufacturing process. For example, to obtain a 75% yield for a 50-step manufacturing process (where a step may indicate the number of layers formed on a substrate), each individual step must have a yield greater than 99.4%. If an individual step has a yield of 95%, the overall yield of the manufacturing process would be as low as 7.7%. It is desirable to determine defects quickly so as to maintain a high substrate throughput, defined as the number of substrates processed per hour.

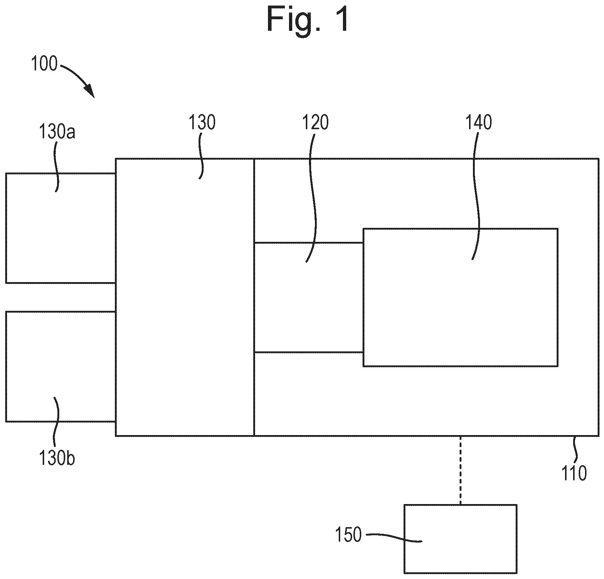

Figure 1 is a schematic diagram illustrating an exemplary assessment apparatus 100, e.g. a metrology apparatus or an inspection apparatus. The assessment apparatus 100 may be configured to scan a sample with one or more beams of electrons. The sample may be a semiconductor substrate, a substrate made of other material, or a mask, for example. The electrons interact with the sample and generate interaction products. The interaction products comprise signal electrons, e.g. secondary electrons and/or backscattered electrons, and possibly X-ray radiation. The assessment apparatus 100 may be configured to detect the interaction products from the sample so that a data set may be generated which may be processable into an image or any other data representation of the scanned area of the sample can be generated. For clarity, the description below focuses on embodiments in which the interaction products that are detected are signal electrons. The assessment apparatus 100 may comprise, for example during operation, a single beam or a plurality of beams, i.e. a multi-beam. The component beams of a multi-beam may be referred to as sub-beams or beamlets. A multi-beam may be used to scan different parts of a sample simultaneously. When the assessment apparatus 100 uses a multi-beam, the assessment apparatus 100 may assess a sample more quickly than when the assessment apparatus 100 uses a single-beam. For example, a higher throughput of sample assessment may be achieved using a multibeam assessment apparatus than a single beam apparatus.

The assessment apparatus 100 of Figure 1 comprises a vacuum chamber 110, a load lock chamber 120, an electron-optical apparatus 140, an equipment front end module (EFEM) 130 and a controller 150. The electron-optical apparatus 140 (also known as an electron beam apparatus or an electron apparatus) may be within the vacuum chamber 110. The electron-optical apparatus 140 may comprise an electron-optical device (described in more detail below) and an actuatable stage. It should be appreciated that reference in the description to the electron-optical elements of the electron-optical apparatus 140 can be considered to be a reference to the electron-optical device.

The EFEM 130 includes a first loading port 130a and a second loading port 130b. The EFEM 130 may include additional loading port(s). The first loading port 130a and the second loading port 130b may, for example, receive substrate front opening unified pods that contain samples. One or more robot arms (not shown) in the EFEM 130 transport the samples to the load lock chamber 120.

The load lock chamber 120 is used to remove the gas around a sample. The load lock chamber 120 may be connected to a load lock vacuum pump system (not shown), which removes gas particles in the load lock chamber 120. The operation of the load lock vacuum pump system enables the load lock chamber to reach a first pressure below the atmospheric pressure. The vacuum chamber 110, which may be a main chamber of the assessment apparatus 100, is connected to a main chamber vacuum pump system (not shown). The main chamber vacuum pump system removes gas molecules from the vacuum chamber 110 so that the pressure around the sample reaches a second pressure equal to or lower than the first pressure. Different parts of the electron-optical apparatus 140 may have different levels of pressure below the atmospheric pressure. After reaching the required pressure, the sample leaves the load lock chamber 120 and is transported to the electron-optical apparatus 140 by which it may be assessed. The electron-optical apparatus 140 may use either a single beam or a multi-beam for the assessment. Alternatively, an electron-optical device array comprising a plurality of electron-optical devices may be used, further also referred to as a multi-column electron-array, in which each electron-optical device (or each column in the multi-column array) comprises, for example during operation, either a single beam or a multi-beam.

The controller 150 is electronically connected to the electron-optical apparatus 140. The controller 150 may be a processor (such as a computer) configured to control the assessment apparatus 100. The controller 150 may also include processing circuitry configured to execute data, signal and image processing functions for example on the data set e.g. embodied as signals such as detection signals. The controller 150 may thus include processing circuitry configured to execute processing functions on signal, image and other data produced in the assessment apparatus 100. While the controller 150 is shown in Figure 1 as being outside of the structure that includes the vacuum chamber 110, the load lock chamber 120, and the EFEM 130, it is appreciated that the controller 150 may be part of the structure. The controller 150 may be located in one of the components of the assessment apparatus 100 or it may be distributed over at least two of the components.

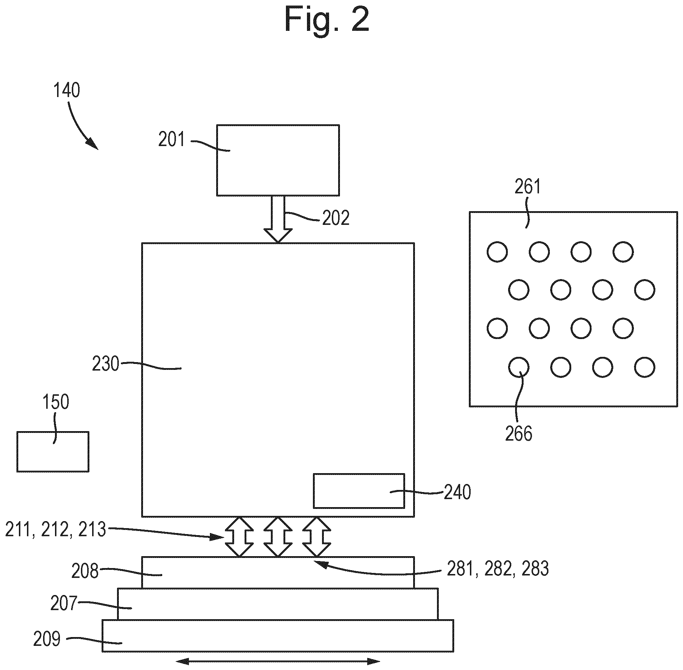

Figure 2 is a schematic diagram illustrating an exemplary electron-optical apparatus 140. The electron-optical apparatus 140 may be provided as part of the assessment apparatus 100 of Figure 1. The electron-optical apparatus 140 includes a source 201 and an electron-optical device 230 (which may also be referred to as an electron-optical column). The source 201 may comprise a cathode (not shown) and an extractor and/or anode (not shown). During operation, the source 201 is configured to emit electrons from the cathode. The electrons may be extracted or accelerated by the extractor and/or the anode to form the source beam 202.

The electron-optical device 230 may be configured to convert the source beam 202 into a plurality of primary beams 211, 212, 213 (which may be referred to as sub-beams or beamlets). The electron-optical device 230 may be configured to direct the primary beams 211, 212, 213 along respective beam paths toward a sample location for the sample 208. Although three beams are illustrated, the number of beams may be of the order of 100s or 1,000s, for example up to 20,000 per electron-optical apparatus 140. The plurality of beams may be referred to collectively as a multi-beam or a beam grid. The different beams may be arranged relative to each other across the beam grid in a pattern. The pattern of the beam grid may be referred to as an array. The electron-optical device 230 has a field of view which may be defined as the area of the surface of the sample 208 within which the primary beams 211, 212, 213 can scan with acceptable aberrations. Alternatively, the field of view may be defined by the maximum scan range of the electron-optical device 230. The field of view may be of the order of millimeters, for example up to 20mm at the sample 208.

The electron-optical device 230 comprises a plurality of electron-optical elements positioned along the beam paths. The electron-optical elements are configured to manipulate the beams. For example, the electron-optical elements may be configured to lens, focus, deflect or correct the beams. The electron-optical elements may be arranged in at least one stack of electron-optical elements. Such an electron-optical element may be positioned upbeam or downbeam with respect to another of the electron-optical elements. The terms upbeam and downbeam relate to the direction of the beams from the source 201 to the sample 208 during use of the electron-optical device 230, which may be expressed as a direction along one or more of the beam paths. In an embodiment some of the different electron-optical elements may take a planar form, such as a plate 261. An electric field that manipulates the beams may be generated between two plates 261, e.g. by applying, in use, different potentials to neighboring/adjoining plates 261 such as along the beam path. An electric field that manipulates the beams may be generated between surfaces of plates 261 across the beam path for example between the neighboring plates 261. One or more beam apertures 266 may be defined in the plates 261 for the passage of one or more beams. The beam apertures 266 may be arranged in a pattern such as a regular grid e.g. hexagonal or square. Such a pattern of the beam apertures 266 may be referred to as an aperture array (i.e. a two-dimensional array over the surface of the plate). The pattern of the beam apertures 266 may correspond to the pattern of beams within the beam grid. Beam apertures 266 in different plates operating on the same beam(s) are typically aligned.

The electron-optical elements may comprise one or more corrector arrays. For example, a corrector array may be integrated into the shape, position and/or size of the beam apertures 266 of the plates 261. The disclosure of such a corrector array as described in WO 2022101072 A1 is hereby incorporated by reference. One or more corrector arrays may comprise multipole deflectors with a specific superposition of potentials applied across the individually controllable electrodes. The disclosure in WO2012165955 of an array of multipole deflectors is hereby incorporated by reference.

One or more of the electron-optical elements may comprise an aperture for the path of a plurality of the beams. For example, the aperture may be a macro aperture for all of the beams. The disclosures of a slit aperture for a collimator or corrector comprising strip electrodes in WO 2021156121 A1 and WO 2021204734 A1 are hereby incorporated by reference. One or more electron-optical elements may comprise one or more plate electrodes that are curved across the path of the beam grid for use as a lens array, a corrector array and/or a collimator array such as disclosed in European patent application 23211553.5 filed 22 November 2023, which is hereby incorporated by reference at least so far as the use and application of curved plate electrodes.

In the current embodiment, the electron-optical device 230 may form three probe spots 281, 282, 283 on the surface of the sample 208. The electron-optical device 230 may be configured to deflect the primary beams 211, 212, 213 so as to scan the probe spots 281, 282, 283 across individual scanning areas of the sample 208. In response to incidence of the primary beams 211, 212, 213 on the sample 208, signal electrons are generated from the sample 208 which may include secondary electrons and backscattered electrons. Secondary electrons typically have electron energy of at most 50 eV. Backscattered electrons typically have electron energy of more than 50 eV and less than the landing energy of the primary beams 211, 212, 213.

The electron-optical apparatus 140 comprises a sample holder 207 that supports a sample 208. The sample holder 207 supports the sample 208 for assessment. The sample holder 207 is supported by an actuatable stage 209. The electron-optical apparatus 140 further comprises a detector array 240. The detector array 240 may be part of the electron-optical device 230. The detector array 240 e.g. detects signal electrons from the sample 208. The detector array 240 generates detection signals based on detection of the signal electrons.

In an embodiment, the detector array 240 may define the surface of the electron-optical apparatus 140 facing the sample 208, e.g. the bottom surface of the electron-optical device 230. There may be more than one detector array at different positions along the paths of the primary beams 211, 212, 213.

The detector array 240 may comprise a plurality of detector elements, with at least one detector element per beam. The detector elements may, for example, be charge capture electrodes, for example metal plates, which may be configured to detect at least some of the signal electrons. Alternatively or additionally, the detector elements may comprise detection diodes configured to detect at least some of the signal electrons. Alternatively or additionally, the detector elements may comprise a scintillator material (such as YAG) configured to convert signal electrons into photons that may be subsequently detected. The detector elements may be arranged around beam apertures 266 in the bottom surface of the electron-optical device 230 to allow the primary beams 211, 212, 213 to pass towards the sample 208. Each detector element may comprise a plurality of detection segments or may constitute a single sensitive surface for each beam. The detection signal generated by a detector element may be transmitted to a processor for generation of an image. For example, the detection signal may represent a grey value or an intensity value of a pixel of an image.

The detector array 240 may send the detection signals, for example as an imaging signal or a detection signal, to the controller 150 or to a signal processing system (not shown) which may be part of the controller 150. The controller 150 or the signal processing system may be configured to generate images of the corresponding scanned areas of the sample 208. The detector array 240 may be incorporated at least partly into the electron-optical device 230. Alternatively, the detector array 240 may be separate from the electron-optical device 230. For example, the electron-optical apparatus 140 may comprise a secondary electron-optical device configured to direct secondary electrons to the detector array 240. In such an embodiment, the secondary electron-optical device comprises a beam separator (such as a Wien filter, not shown). The beam separator may separate the paths of the primary electrons towards the sample 208 from the paths of the signal electrons away from the sample 208. Note, such a beam separator may be present in a different embodiment with a detector array within the electron-optical device 230 for directing the primary electrons towards the sample and the signal particles to detector elements of the detector array.

The controller 150 (for example a control system comprising distributed controllers) may be connected to various parts (e.g. components) of the electron-optical apparatus 140 of Figure 2, such as the source 201, the detector array 240, the electron-optical device 230, and the actuatable stage 209. The controller 150 may perform various image processing functions and signal processing functions. The controller 150 may also generate various control signals to govern operations of the assessment apparatus 100.

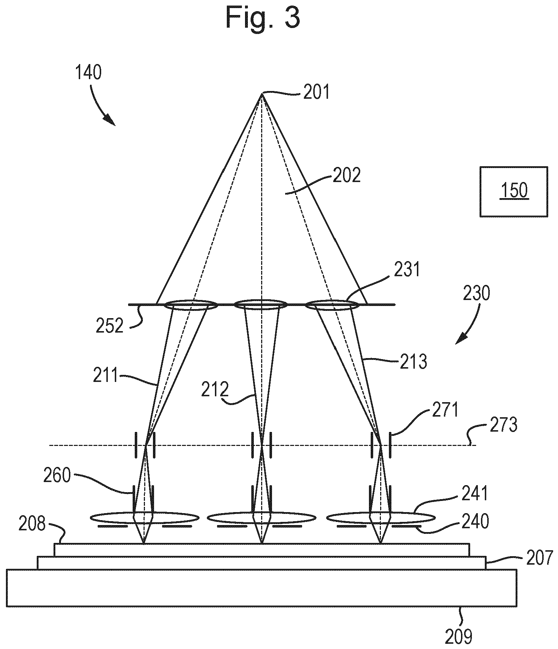

Figure 3 schematically depicts an electron-optical apparatus 140 of an assessment apparatus, e.g. the assessment apparatus 100 of Figure 1. The electron-optical apparatus 140 of Figure 3 may be the electron-optical apparatus 140 of Figure 2 in which the electron-optical elements of the electron-optical device 230 comprise a beam limiting aperture array 252, a condenser lens array 231, a collimator array 271 desirably at an intermediate focus plane 273, a scan deflector array 260, an objective lens array 241 and the detector array 240.

The source 201 generates a diverging source beam 202. The beam limiting aperture array 252 defines a plurality of primary beams 211, 212, 213 from the source beam 202. The condenser lens array 231 focuses the primary beams 211, 212, 213 at the intermediate focus plane 273. The condenser lens array 231 may comprise the beam limiting aperture array 252. Alternatively, the condenser lens array 231 may be downbeam of the beam limiting aperture array 252. The condenser lens array 231 may be electrostatic. In an alternative embodiment the condenser lens array 231 comprises one or more magnetic elements.

The collimator array 271 is configured to collimate the primary beams 211, 212, 213 along respective beam paths towards and substantially orthogonal to a surface of the sample 208. The collimator array 271 may be located at or near the intermediate focus plane 273. The collimator array 271 may comprise a plurality of deflectors configured to deflect respective primary beams 211, 212, 213. Additionally or alternatively the collimator array 271 may comprise a lens array that operates on the different beams to deflect the relative paths of the beams. The collimator array 271 may be electrostatic. The collimator array 271 may consist of a single plate 261 comprising electrodes around the beam apertures 266, such as on the surface around the beam apertures 266 and/or on the inside of the beam apertures 266. The electrodes may cooperate as a deflector per beam aperture 266. Alternatively, the collimator array 271 may comprise a stack of plates 261. In use a potential difference is applied between the plates 261 so as to generate a lensing effect at the beam apertures 266. The plates 261 may have a curvature across the beam path. Alternatively, the collimator array 271 may comprise a plurality of layers of strip electrode deflectors as shown in WO2021156121 and WO2021204734. A layer of strip electrode deflectors may consist of a plate. Although not shown in Figure 3, in an alternative embodiment the collimator array 271 is replaced by a macro collimator configured to collimate the primary beams 211, 212, 213. The macro collimator may be a magnetic lens, or an electrostatic lens, or a combination of magnetic and electrostatic lens. In a further alternative embodiment, the electron-optical device 230 comprises a macro collimator in addition to the collimator array 271.

The deflectors of the scan deflector array 260 may be formed at apertures of the scan deflector array 260. The deflectors may comprise respective sets of individually controllable electrodes. Such a deflector may be referred to as a multipole deflector. The individually controllable electrodes extend partially along the beam path of the respective beam. The individually controllable electrodes may be controlled to generate, in use, a scan movement of the respective beam across the sample 208. Typically, the sets of individually controllable electrodes operate to scan all of the primary beams 211, 212, 213 simultaneously in parallel across the individual fields of view of the respective objective lenses of the objective lens array 241. Alternatively, the scan deflector array 260 may comprise strip deflectors (as shown in WO2004081910, WO2021156121 and WO2021204734) configured to deflect a row of beams along the individual fields of view of the respective objective lenses of the objective lens array 241.

The objective lens array 241 is configured to focus the primary beams 211, 212, 213 onto the sample 208. The objective lens array 241 may comprise a stack of plates 261. Different potentials are applied to respective plates 261 so as to generate electrostatic fields between adjacent plates 261. The electrostatic fields generate electrostatic lenses that may be configured to focus the primary beams 211, 212, 213. The objective lens array 241 may be proximate the sample 208.

The stack of plates 261 of the objective lens array 241 may be referred to as, or as part of, an objective lens assembly. The objective lens assembly may comprise one or more of the scan deflector array 260, a corrector array (not shown) and the detector array 240 in addition to the objective lens array 241. The objective lens assembly may comprise additional plates having lens functionality providing additional degrees of electron-optical freedom. A control lens array may be comprised by such an additional plate. As described in WO 2022/101072 A1, the control lenses pre-focus the sub-beams (e.g. apply a focusing action to the sub-beams prior to the sub-beams reaching the objective lens array 241). The pre-focusing may reduce divergence of the sub-beams or increase a rate of convergence of the sub-beams

In an embodiment the detector array 240 may be integrated into the objective lens array 241. Alternatively (or additionally) the detector array 240 may be upbeam of the bottom surface of the electron-optical device 230. For example, the detector array 240 may be within the objective lens assembly or even upbeam of the objective lens assembly. For example, the detector array 240 may be in or upbeam of the objective lens array 241.

The disclosures in EP 3869535 A1 and WO 2021165136 A1 of a source, a condenser lens array, a collimator array, an objective lens array and a detector array are hereby incorporated by reference.

The electron-optical device 230 may comprise one or more corrector arrays configured to at least partly correct one or more types of aberration of the beams. Such corrector arrays may be associated with or integrated into the condenser lens array 231, the collimator array 271 and/or the objective lens array 241, or between two of these arrays, e.g. between the condenser lens array and the collimator array.

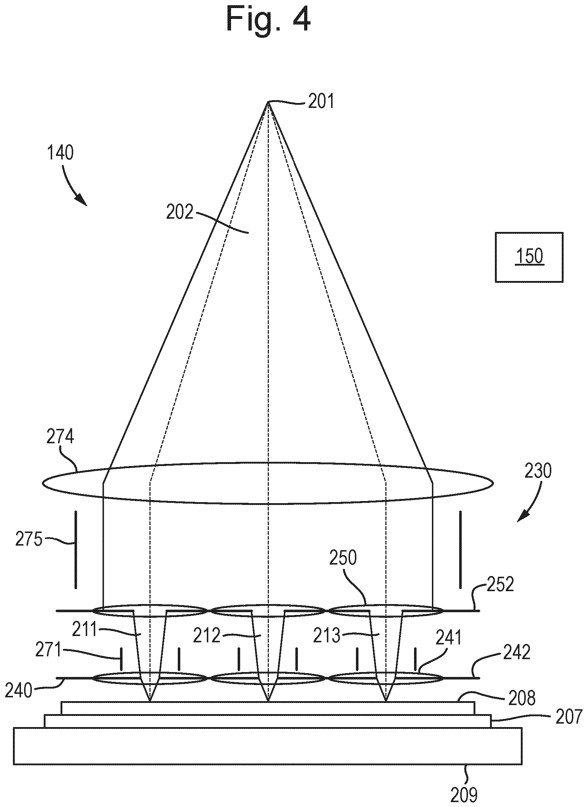

Figure 4 schematically depicts an electron-optical apparatus 140 of an assessment apparatus, e.g. the assessment apparatus 100 of Figure 1. The electron-optical apparatus 140 of Figure 4 may be the electron-optical apparatus 140 of Figure 2 in which the electron-optical device 230 comprises a macro condenser lens 274, a macro scan deflector 275, a beam limiting aperture array 252 (which may be referred to as an upper beam limiter), a control lens array 250, a collimator array 271, an objective lens array 241, a beam shaper array 242 (which may be referred to as a lower beam limiter) and the detector array 240.

The source 201 generates a diverging source beam 202. The macro condenser lens 274 is located between the source 201 and the objective lens array 241. The macro condenser lens 274 is configured to at least partly collimate the source beam 202. The macro scan deflector 275 is located between the macro condenser lens 274 and the objective lens array 241. The macro scan deflector 275 is configured to operate on the source beam 202 so that the primary beams 211, 212, 213 scan the surface of the sample 208. Additionally or alternatively the electron-optical device 230 may comprise a scan deflector array (not shown) downbeam of the control lens array 250. The macro condenser lens 274 and/or the macro scan deflector 275 may at least in part be magnetic.

The beam limiting aperture array 252 defines a plurality of primary beams 211, 212, 213 from the source beam 202. The beam shaper array 242 and the beam limiting aperture array 252 are plates 261 in which the beam apertures 266 are smaller in dimension than other plates of the electron-optical device 230. The beam apertures 266 of the beam limiting aperture array 252 define the primary beams 211, 212, 213. The beam apertures 266 of the beam shaper array 242 shape the primary beams 211, 212, 213 to at least partially correct for types of aberration in the beams.

The collimator array 271 is configured to collimate the primary beams 211, 212, 213 along respective beam paths towards and substantially orthogonal to a surface of the sample 208. The collimator array 271 may be located between the beam limiting aperture array 252 and the objective lens array 241. The collimator array 271 may be omitted. Alternatively, when the collimator array 271 is provided, then the macro condenser lens 274 may be omitted. The collimator array 271 may comprise a plurality of deflectors configured to deflect respective primary beams 211, 212, 213. The collimator array 271 may be electrostatic. The collimator array 271 may consist of a single plate 261 comprising the deflectors around the beam apertures 266, for example on the surface around the beam apertures 266 and/or on the inside of the beam apertures 266. Alternatively, the collimator array 271 may comprise a stack of plates 261. In use a potential difference is applied between the plates 261 so as to generate a lensing effect at the beam apertures 266. One or more of the plates may be curved across the path of the beam grid. Alternatively or additionally, the collimator array 271 may comprise a plurality of layers of strip electrode deflectors. A layer of strip electrode deflectors may be a plate.

The objective lens array 241 is configured to focus the primary beams 211, 212, 213 onto the sample 208. The objective lens array 241 may comprise a stack of plates 261. In use, different potentials may be applied to respective plates 261 so as to generate electrostatic fields between adjacent plates 261. The electrostatic fields generate electrostatic lenses that may be configured to focus the primary beams 211, 212, 213. The objective lens array 241 may be proximate the sample 208.

The control lens array 250 may be upbeam of the objective lens array 241. The control lens array 250 may comprise a stack of plates 261, for example at least three plates 261. The control lens array 250 may be configured to control electron-optical parameters of the primary beams 211, 212, 213. In an embodiment, the most downbeam plate of the control lens array 250 is the most upbeam plate of the objective lens array 241. Alternatively, the control lens array 250 may be considered to be part of the objective lens array 241. The control lens array may provide one or more additional degrees in electron-optical freedom such as in pre-focusing, magnification and beam current setting.

The stack of plates 261 of the objective lens array 241 may be referred to as an objective lens assembly. The objective lens assembly may comprise one or more of the beam limiting aperture array 252, the control lens array 250, a corrector array (not shown), the collimator array 271, the beam shaper array 242 and the detector array 240 in addition to the objective lens array 241. The objective lens assembly may comprise additional plates having lens functionality providing additional degrees of electron-optical freedom. A control lens array may be comprised by such an additional plate.

In an embodiment the detector array 240 may be integrated into the objective lens array 241. Alternatively (or additionally) the detector array 240 may be upbeam of the bottom surface of the electron-optical device 230. For example, the detector array 240 may be within the objective lens assembly or even upbeam of the objective lens assembly. For example, the detector array 240 may be in or upbeam of the objective lens array 241.

The disclosures in EP 3869535 A1 and WO 2021165136 A1 of a source, an objective lens array and a detector array are hereby incorporated by reference. The disclosure in WO2022058252 A1 of the collimator array, the macro condenser lens, the macro scan deflector, and the need for a beam limiting aperture array and a beam shaper array is incorporated by reference.

The electron-optical device 230 may comprise one or more corrector arrays (not shown) configured to at least partly correct one or more types of aberration of the beams. Such corrector arrays may be associated with or integrated into the control lens array 250, the collimator array 271 and/or the objective lens array 241, for example as part of the objective lens assembly.

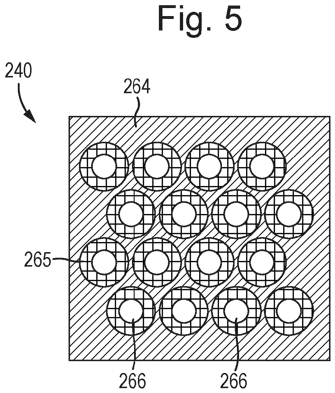

Figure 5 is a bottom view of the detector array 240 which comprises a detector substrate 264 on which are provided a plurality of detector elements 265 each surrounding a beam aperture 266. The detector array 240 may be provided at a downbeam surface of a plate 261 comprising beam apertures 266. In an embodiment, the detector elements 265 are charge capture electrodes, for example metal plates. The beam apertures 266 may be formed by etching through the detector substrate 264. In the arrangement shown in Figure 5, the beam apertures 266 are in a hexagonal close packed array. The beam apertures 266 can also be differently arranged in any other suitable array arrangement, e.g. in a rectangular or square array.

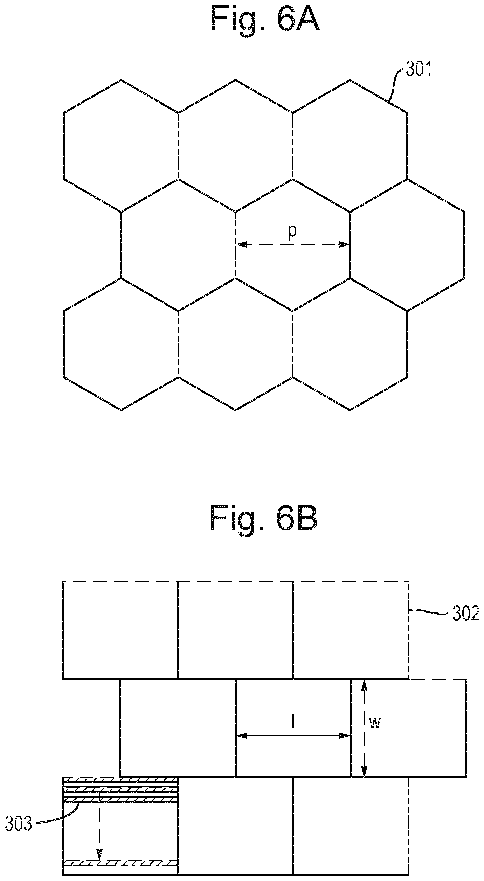

Figure 6A depicts a hexagonal grid, based on hexagonal unit cells 301 having width p, that is a convenient arrangement for the charged particle beams of a multi-beam charged-particle optical device. The array pitch, i.e. the center to center distance for adjacent cells, is p. The array pitch is the distance between the centers of adjacent beam apertures of electrode plates in the downbeam part of the column in which the charge-particle beams are mutually collimated (i.e. parallel). For example, p may be in the range of from 50 $\mu$m to 150 $\mu$m. Each beam channel, comprising beam directing elements and a detector element, fits with a unit cell 301. To scan the whole area of a sample, each beam can be arranged to scan a respective scan area 302, wherein the scan areas 302 completely tile the area of the sample, as shown in Figure 6B. Conveniently, scan areas 302 are rectangles of length 1 and width w, where 1 = p and $w = \frac{\sqrt{3}}{2}p$ . Alternate rows are offset by a distance p/2.

To scan the scan areas 302, the sample is mechanically scanned by the actuatable stage 209 in a first direction, e.g. parallel to the longitudinal direction of the scan areas 302, which may be referred to as the X direction. The electron beams are simultaneously scanned in a second direction, e.g. orthogonal to the first direction and referred to as the Y direction, by a small amount by scan deflector array 260. The scanning range, i.e. the distance between the undeflected position of each beam and the extreme positions of the beam on the sample as effected by the scan deflector array, may be much smaller than the pitch p, e.g. in the range of from p/100 to p/50. When the sample has been moved by a distance p in the first direction, it is shifted in the second direction by a distance at least equal to the scanning range of the scan deflector array and scanned back in the first direction. By repeating this process the scan area 302 is scanned completely by a series of narrow scan strips 303. This process may be referred to as a hybrid leap and scan and is efficient to scan the complete area of the sample.

In some cases, it may be sufficient when assessing samples to only assess selected parts of the sample. For example, the structures formed on a sample may include a limited number of critical parts, that is parts that are critical to the functioning of devices being fabricated. In some cases, there may be a limited number of sensitive parts, that is parts of the structures that are especially susceptible to imaging errors or other defects. In some cases, assessment targets that do not form part of functional devices may be included in the patterns that are imaged, e.g. in scribe lanes. A given sample may have any combination of critical parts, sensitive parts and assessment targets.

If the total area of the critical parts, sensitive parts or assessment targets is much smaller than the total area of the sample, the throughput of an assessment process, measured in samples per hour, may be greatly increased by only assessing selected parts - e.g. the critical parts, sensitive parts or assessment targets - rather than the whole sample, or large areas of the sample.

However, in the case of a multi-beam assessment apparatus, it may not be possible to achieve the whole advantage of assessing only selected parts of the sample if the selected parts are arbitrarily located on the sample. If the arrangement of selected parts to be assessed does not match the arrangement of the beams - which is generally in the form of a regular array or grid - then when the sample is positioned to assess a given part with one beam, other beams may be directed to parts of the sample that are of little or no interest. In effect, the full capacity of the multi-beam assessment apparatus is not used.

Ideally, the selected parts to be assessed would be arranged on the sample to match the arrangement of the beams of the multi-beam assessment apparatus so that all of the beams could be usefully employed to simultaneously assess the selected parts of the sample. However, this may not be possible to achieve, for example because of other constraints of the structures to be formed. Also, at the time of designing a pattern to be applied to a substrate, the designer may not know which of a plurality of measurement targets will be most relevant to monitoring the performance of the fabrication process nor what assessment apparatus will be used to monitor the fabrication process.

Therefore, it is desirable to provide a multi-beam assessment apparatus that has greater flexibility in the arrangement of target areas that can be simultaneously assessed.

A multi-beam charged particle-optical device according to an embodiment of the invention is configured so that one or more beams of a plurality of beams are incident at the substrate with a different pitch (or spacing) relative to their neighbors than others of the plurality of the plurality of beams. For example, many of the beams may be incident at the substrate at points of a regular grid (e.g. a rectangular array or a hexagonal array) but a subset of the beams is incident at positions offset from the nearest point of the regular grid. In this arrangement, each beam of the subset may have a unique offset (direction and distance) or some beams in the subset may have the same offset. In an extreme case, the multi-beam charged particle-optical device may define a regular grid but all beams are incident at the substrate at positions offset from the regular grid.

In one aspect, the charged particle-optical device comprises a deflector array located adjacent to an objective lens arrangement. The deflector array is configured to selectively deflect one or more of the plurality of charged particle beams so that at least one of the plurality of charged particle beams has a different pitch with respect to its nearest neighbors. The charged particle-optical device may be configured so that the objective lens arrangement focusses the plurality of charged particle beams onto the sample in a regular grid. Each beam may have a field of view and the deflector may be configured to selectively deflect the beams within the respective field of view.

The provision of the deflector array allows individual ones of the charged-particle beams to be directed to desired locations on the sample that are displaced or offset from the regular grid, and have different pitches with respect to their neighbors. This means that a plurality of beams can be used to simultaneously assess locations on the sample that are spaced apart by different distances than the regular grid or are arranged arbitrarily on the sample. The full throughput advantage of a multi-beam apparatus may therefore be obtained even when assessing only selected areas of the sample. The deflector array enables the locations of incidence of the individual beams on the sample to be controlled at the time of assessment, enabling flexibility in the arrangement of areas of the sample that are selected for assessment. For different patterns on the sample, different areas may be selected for assessment.

Desirably, the deflector array is located adjacent an electrode plate that has the strongest lens action amongst all the electrode plates of the charged particle-optical device. In this way, the distance by which the locations of incidence of the individual charged particle beams on the sample can be displaced is maximized. In addition, by placing the deflector array close to the electrode plate that has the strongest lens action, the displacement of the beam in that strongest lens is minimized, and therefore additional aberrations are minimized (the more a beam is in the center of a lens, the smaller the aberrations). As a result it is possible to effect a larger deflection without unacceptable aberrations.

The charged particle-optical device may further comprise an actuatable stage configured to support the sample and scan the sample in a first direction; and a scan deflector configured to scan the plurality of charged particle beams in a second direction substantially perpendicular to the first direction. The scan deflector may be a scan deflector array or a macro scan deflector. The deflector array may be configured to deflect selected ones of the charged particle beams by a distance that is larger than the scanning range of the scan deflector.

In another aspect, a charged particle-optical device comprises a plurality of first electrode plates each having a first array of beam apertures and all the first arrays are aligned with each other. The charged particle-optical device also has a second electrode plate having a second array of beam apertures wherein at least one beam aperture of the second array is not aligned with the beam apertures of the first array. The positions of the beam apertures in the second electrode plate affect the locations of incidence of the charged particle beams on the sample so that selected ones of the beams can be directed to locations displaced from the grid defined by the first array. Hence, similarly to the first apparatus, the full advantage of a multi-beam charged particle-optical device may therefore be obtained even when assessing only selected areas of the sample.

The relative arrangement of locations to be inspected is determined at the time of manufacture of the second electrode plate. Thus, there is less flexibility than when using a controllable deflector, as in the first aspect, but the manufacture of a single electrode plate to match a given pattern is much easier and quicker than manufacturing a complete charged particle-optical device to a custom arrangement of beams. Desirably, the second electrode plate is a field replaceable component so that second electrode plates may be swiftly interchanged to assess different patterns.

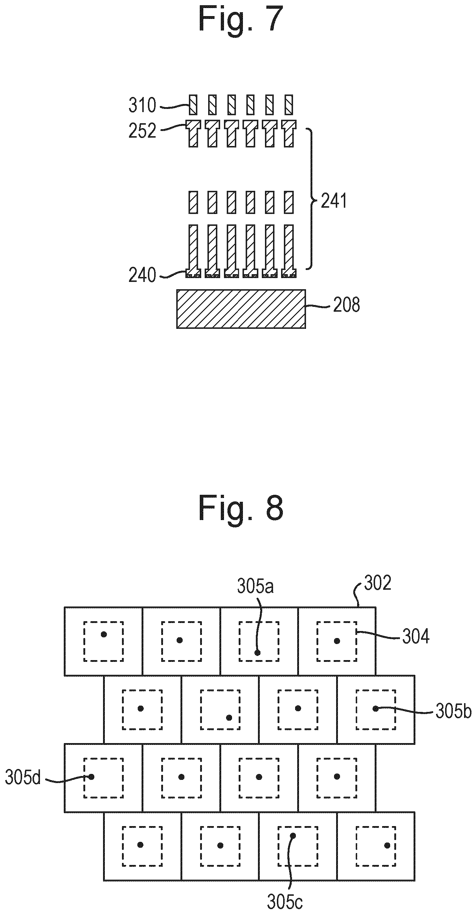

Figure 7 depicts schematically relevant components of a charged-particle optical device of an embodiment and Figure 8 illustrates the effect of a deflection array. A deflector array 310 is provided upbeam of objective lens array 241. Deflector array 310 is configured to selectively deflect each of the plurality of charged-particle beams so that the points of incidence 305a-d (shown in Figure 8) of the beams on sample 208 are individually controllable. In another embodiment, the deflector array 310 is configured to selectively deflect at least a subset or one or more of the plurality of charged particle beams.

In the embodiment of Figure 7, the deflector array 310 is adjacent the upbeam electrode plate of the objective lens array. Deflector array 310 is desirably located adjacent the electron-optic element, or electrode plate, that has the strongest lens action in the charged-particle optical device in order to maximize the distance at the sample by which the beams can be deflected. In the case of a charged-particle optical device having a relatively high landing energy, the most upbeam electrode plate of the objective lens array has the strongest lens effect. Nevertheless, the offset range 304, being the range on the sample within which a beam can be made incident, is smaller than the field of view 302 which is covered by the mechanical scan of the substrate and is the area that can be covered by a single beam. Desirably, the offset range has a dimension in at least one direction that is equal to or greater than 1 % of the array pitch.

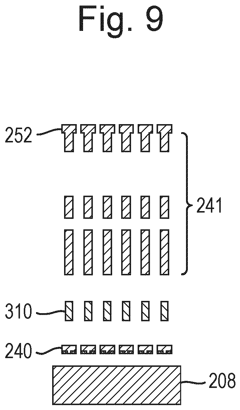

A variant of the embodiment of Figure 7 is depicted in Figure 9. Here, the deflector array 310 is located downbeam of the objective lens array 241 and upbeam of the detector array 240. In other words, the deflector array is located between the most downbeam electrode plate of the objective lens array 241 and the detector array 240. Other features of this embodiment are the same as corresponding features of the embodiment of Figure 7. The embodiment of Figure 9 is particularly useful in a charged-particle optical device having a relatively low landing energy such that the objective lens array is a decelerating lens and so the lower electrode plate thereof has the strongest lens action..

The charged-particle optical device desirably includes a scan deflector that scans the beams in one direction by a scan range. Desirably, the deflection range is larger than the scan range. During scanning the scan deflector array applies the same alternating deflection to all of the charged particle beams. The deflector array 310 applies individually controllable deflections to selected ones of the charged particle beams that are constant over a period longer than the period of the scan deflector. In many cases, the deflector array will apply a constant deflection during the whole time a sample is assessed. This may be the case when only one location per scan region 301 is to be assessed or if there are multiple locations in each scan region that are similarly arranged across all scan regions. If more than one location per scan region is to be assessed, it may be convenient to set a first set of deflections and assess a first set of locations, then set a second set of deflections and assess a second set of locations, repeating as necessary.

In some cases the functions of the deflector array 310 and scan deflector array can be combined by superimposing an alternating signal to effect the scan deflection on the relatively static individual deflections that determine the assessment locations.

Deflector array 310 may comprise an array of individually controllable multipole deflectors. For example, deflector array 310 may comprise quadrupole deflectors such as described in US2023109236A1, which document is hereby incorporated by reference in its entirety and specifically in relation to the disclosure therein of a beam manipulator. For example, deflector array 310 may comprise octupole deflectors such as described in PCT Application No: PCT/EP2024/055111, international filing date: 28 Feb 2024, which document is hereby incorporated by reference in its entirety and specifically in relation to the disclosure therein of a charged-particle optical plate.

Embodiment of the invention may also comprise a further deflector array configured to deflect one or more of the charged particle beams deflected by the deflector array so as to reduce an incident angle variation between the plurality of charged particle beams on the sample surface. The further deflector array may be located at the other side of the objective lens array 241 than the deflector array. Thus, if the deflector array is adjacent an upbeam electrode plate of the objective lens array 241, the further deflector array is located adjacent the downbeam electrode plate of the objective lens array 241 and vice-versa.

In view of the deflection or offsetting of the beams, the beam apertures in electrode plates that are downbeam of the deflector array 310 may be larger than is customary. For example, the beam apertures of electrode plates downbeam of the first deflector array have a diameter at least equal to 5% of the array pitch. This is desirable to avoid or minimize beams that are displaced from their default position being occluded by downbeam electrode plates which might result in varying beam intensities. Desirably, the larger the deflection range 304, the larger the beam apertures of downbeam electrode plates. However, it is desirable that the beam apertures in the detector array 240 are not made any larger than necessary since enlarging these beam apertures increases the detector blind spot and so decreases detector efficiency.

The charged-particle optical device may be provided with an optical device configured to illuminate the sample with light. Illuminating the sample controls the conductivity of the sample, due to the excitation of charge carriers, and may increase contrast when assessing the sample to detect certain types of defect. This is known as Advanced Charge Control or ACC. In an embodiment, the optical device for ACC may be located adjacent the deflector array 310. It is convenient to provide the optical device and the deflector array 310 on the same substrate. Desirably the deflector array is upbeam of the optical device since the larger the distance between the deflector array 310 and the sample, the larger the beam offset that can be achieved.

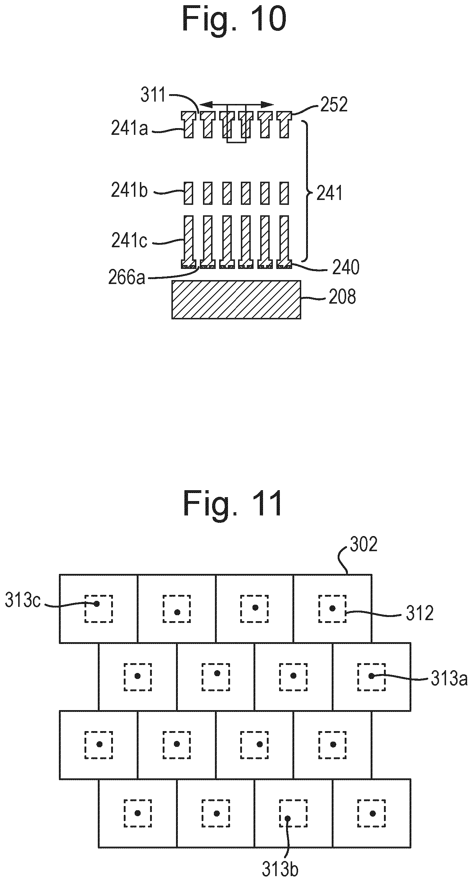

Another embodiment of the invention is described below with reference to Figures 10 and 11. In this embodiment, one electrode plate in the stack of electrode plates that makes up the charged-particle optical device is custom-made to create beam offsets that enable an efficient scanning of a particular arrangement of locations on a sample. Thus, a plurality of first electrode plates, e.g. the two downbeam electrode plates 241b, 241c of objective lens array 241, are manufactured to a standard arrangement of beams, e.g. having a first array of beam apertures. The first array may be a hexagonal array, a rectangular array or any other type of regular array. A second electrode plate, e.g. upbeam electrode plate 241a of objective lens array 241, has beam apertures 311 arranged in a second array in which at least one beam aperture is not aligned with any beam aperture of the first array of beam apertures.

The offset of a beam aperture in the second electrode plate causes an offset or displacement of the corresponding beam at the sample. This is illustrated in Figure 9 which shows some beams, e.g. beam 313a, incident at the center of respective scan regions 302 in accordance with the first array of beam apertures. Other beams, e.g. 313b, 313c, are incident at positions offset from the centers of the scan regions 302 as a result of offset beam apertures in the second array.

Desirably, the second electrode plate is the electrode plate in the charged-particle optical device which has the strongest lens action to maximize the possible offset at the sample. Nevertheless, the incidence range 312 within which a beam may be directed is likely to be smaller than in the arrangement of Figure 7. It is also to be noted that the locations of incidence of the beams are fixed at the time of manufacture of the second electrode plate. A scan deflector may be included to effect a scan in one direction as described above, so that in combination with a mechanical scan an area around each beam incidence point can be scanned.

The second electrode plate is designed for use with a specific arrangement of locations to be assessed. The design and manufacture time of a single electrode plate may be considerably shorter than the time required to manufacture a complete charged-particle optical device. Desirably, the second electrode plate does not include the detector array 240, which is generally the most complex element to manufacture amongst the charged-particle optical device. The detector array can be manufactured with slightly larger beam apertures 266a (when compared to the size of beam apertures in the detector array where such a modification is not made in the second electrode plate) in order to accommodate the resultant beam offsets..

It is possible to manufacture more than one electrode plate with beam apertures aligned to the second array, e.g. if such electrode plates are adjacent and simple to manufacture. It is desirable that the second electrode plate incorporates a beam limiting aperture array 252. Desirably, the second electrode plate, and any other electrode plates with the same array of apertures are formed as a replaceable or field replaceable module. In this way, the charged particle optical device may easily be adapted to scan a different arrangement of locations.

In an embodiment any electron-optical element or group of electron-optical elements may be replaceable or field replaceable within the electron-optical apparatus 140. Field replaceability means that the electron-optical element or group of electron-optical elements may be replaced without substantially disassembling the electron-optical apparatus 140. In an embodiment the electron-optical apparatus 140 comprises at least one module. Each module comprises a group of adjacent electron-optical elements. The electron-optical elements of a module may be secured to each other, for example as a stack.

Features in electron-optical plates may be manufactured using techniques from microelectromechanical systems (MEMS) (i.e. using MEMS manufacturing techniques). MEMS are miniaturized mechanical and electromechanical elements that are made using microfabrication techniques. Merely as an example, a collimator array may be formed using MEMS manufacturing techniques so as to be spatially compact. As another example, a scan deflector array may be formed using MEMS manufacturing techniques.

Although specific reference may be made in this text to embodiments of the invention in the context of an electron microscope, embodiments of the invention may be used in other types of apparatus. Embodiments of the invention may form part of a mask inspection apparatus, a metrology apparatus, or any apparatus that measures or processes an object such as a wafer (or other substrate) or mask (or other patterning device).

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

Embodiments of the invention are described below in the following numbered clauses.

1. A charged particle-optical device configured to direct a plurality of charged particle beams along respective beam paths towards a sample surface, the charged particle-optical device comprising:

an objective lens arrangement having a plurality of electrode plates arranged to focus the plurality of charged particle beams onto the sample surface in a grid; and

a deflector array located adjacent one of the plurality of electrode plates, wherein the deflector array is configured to deflect one or more of the plurality of charged particle beams so that at least one of the plurality of charged particle beams has a different pitch with respect to its nearest neighbors.

2. A charged particle-optical device according to clause 1, wherein the one of the plurality of electrode plates adjacent the deflector array is configured to have the strongest lens action.

3. A charged particle-optical device according to clause 1 or 2, wherein the deflector array is configured to deflect the one or more charged particle beams within a respective field of view of the one or more charged particle beams.

4. A charged particle-optical device according to any preceding clause, wherein the one of the plurality of electrode plates adjacent the deflector array is further configured to comprise a beam limiting aperture array.

5. A charged particle-optical device according to any preceding clause wherein the plurality of electrode plates comprises an upbeam electrode plate and a downbeam electrode plate, wherein the upbeam electrode plate is configured to have the strongest lens action and the deflector array is located upbeam of the said upbeam electrode plate.

6. A charged particle-optical device according to clause 5, comprising a further deflector array located adjacent the downbeam electrode plate, the further deflector array configured to deflect one or more of the charged particle beams deflected by the deflector array so as to reduce an incident angle variation between the plurality of charged particle beams on the sample surface.

7. A charged particle-optical device according to any of clauses 1 to 4, wherein the plurality of electrode plates comprises an upbeam electrode plate and a downbeam electrode plate, wherein the downbeam electrode plate is configured to have the strongest lens action and the deflector array is located downbeam of the downbeam electrode plate.

8. A charged particle-optical device according to clause 7, further comprising a detector array facing the sample surface and wherein the deflector array is located between the said downbeam electrode and the detector array.

9. A charged particle-optical device according to clauses 7 or 8 comprising a further deflector array located adjacent the upbeam electrode plate, the further deflector array configured to deflect one or more of the charged particle beams deflected by the deflector array so as to reduce an incident angle variation between the plurality of charged particle beams on the sample surface.

10. A charged particle-optical device according to any one of the preceding clauses further comprising:

an actuatable stage configured to support the sample and scan the sample in a first direction; and
a scan deflector configured to scan the plurality of charged particle beams in a second direction substantially perpendicular to the first direction.

11. A charged particle-optical device according to clause 10 wherein the deflector array is configured to deflect one or more of the plurality of charged particle beams by a greater distance at the sample surface than the scan deflector.

12. A charged particle-optical device according to any one of the preceding clauses further comprising an optical device configured to direct electromagnetic radiation to the sample location, wherein the deflector array is adjacent the optical device.

13. A charged particle device according to clause 12 wherein the deflector array is upbeam of the optical device.

14. A charged particle device according to clause 12 or 13 wherein the optical device and the deflector array are provided on the same substrate.

15. A charged particle-optical device according to any one of the preceding clauses wherein at least one electrode plate of the plurality of electrode plates comprises beam apertures arrayed in accordance with an array pitch.

16. A charged particle-optical device according to clause 15 wherein the deflector array is configured to deflect one or more of the plurality of charged particle beams by a distance at the sample surface of at least 1% of the array pitch.

17. A charged particle-optical device according to clause 15 or 16, wherein the beam apertures of electrode plates downbeam of the deflector array have a diameter at least equal to 5% of the array pitch.

18. A charged particle-optical device configured to direct a plurality of charged particle beams along respective beam paths towards a sample surface, the charged particle-optical device comprising an objective lens arrangement having:

a one or more first electrode plates, each electrode plate having an array of first beam apertures, the array of first beam apertures of the respective first electrode plates being aligned with each other; and
a second electrode plate located adjacent one of the first electrode plates, wherein the second electrode plate has a plurality of second beam apertures and wherein at least one of the second beam apertures has a different alignment to the array of first beam apertures when compared to an alignment of the remainder of the plurality of second beam apertures to the array of the first beam apertures, so that at least one of plurality of charged particle beams has a different pitch with respect to its nearest neighbors.

19. A charged particle-optical device according to clause 18, wherein the array of first beam apertures has an array pitch and the at least one of the second beam apertures is displaced from a corresponding one of the first beam apertures by a distance of at least 1 % of the array pitch.

20. A charged particle-optical device according to clause 18 or 19 wherein the second electrode plate is upbeam from the plurality of first electrode plates, wherein the array of first beam apertures has an array pitch and the beam apertures of the plurality of first electrode plate downbeam of the second electrode plate have a diameter at least equal to 5% of the array pitch.

21. A charged particle-optical device according to clause 18, 19 or 20 wherein the second electrode plate is a field replaceable element.

22. A charged particle-optical device according to clause 18, 19, 20 or 21, further comprising a beam limiting aperture array, wherein the beam limiting apertures are aligned to the second beam apertures.

23. A charged particle-optical device according to any one of clauses 18 to 22, wherein the second electrode plate is configured to have the strongest lens action.

24. A charged particle-optical device according to any one of clauses 18 to 23 further comprising:

an actuatable stage configured to support the sample and scan the sample in a first direction; and

a scan deflector configured to scan the plurality of charged particle beams in a second direction substantially perpendicular to the first direction.

25. A charged particle-optical device according to clause 24 wherein the array of first beam apertures has an array pitch and the at least one of the second beam apertures is displaced from a corresponding one of the first beam apertures by a distance greater than the scanning range at the sample surface of the scan deflector.

26. A method of assessing a sample using an assessment apparatus comprising a charged particle-optical device configured to direct a plurality of charged particle beams onto the sample, the charged particle-optical device having a plurality of electron-optic electrodes; and a deflector array located adjacent the one of the plurality of electron-optic electrodes wherein the deflector array is configured to deflect one or more of the plurality of charged particle beams, the method comprising energizing the deflector array to deflect one or more of the plurality of charged particle beams so that the at least one of the plurality of charged particle beams has a different pitch with respect to its nearest neighbors.

27. A field-replaceable electrode plate for an objective lens arrangement of a charged particle-optical device, wherein the field-replaceable electrode plate comprises a plurality of apertures and wherein at least one of the apertures has a different pitch with respect to its nearest neighbours.

While specific embodiments of the invention have been described above, it will be appreciated that the invention may be practiced otherwise than as described. The descriptions above are intended to be illustrative, not limiting. Thus, it will be apparent to one skilled in the art that modifications may be made to the invention as described without departing from the scope of the claims set out below.

List of reference numerals:

100 assessment apparatus
110 vacuum chamber (main chamber)
120 load lock chamber
130 EFEM
130a first loading port
130b second loading port
140 electron-optical apparatus (electron beam apparatus, electron apparatus)
150 controller
201 source
202 source beam
207 sample holder
208 sample
209 actuatable stage
211, 212, 213 primary beams (sub-beams, beamlets)
230 electron-optical device (electron-optical column)
231 condenser lens array
240 detector array
241 objective lens array
241a, b, c electrode plates
242 beam shaper array
250 control lens array
252 beam limiting aperture array
260 scan deflector array
261 plate
264 detector substrate
265 detector elements
266, 266a beam apertures
271 collimator array
273 intermediate focus plane

274 macro condenser lens
275 macro scan deflector
301 unit cell
302 scan region
303 scan strips
304 deflection range
305 default point of incidence
310 deflector array
311 second array of beam apertures

**Claims**

1. A charged particle-optical device configured to direct a plurality of charged particle beams along respective beam paths towards a sample surface, the charged particle-optical device comprising:

   an objective lens arrangement having a plurality of electrode plates arranged to focus the plurality of charged particle beams onto the sample surface in a grid; and
   a deflector array located adjacent one of the plurality of electrode plates, wherein the deflector array is configured to deflect one or more of the plurality of charged particle beams so that at least one of the plurality of charged particle beams has a different pitch with respect to its nearest neighbors.

2. A charged particle-optical device according to claim 1, wherein the one of the plurality of electrode plates adjacent the deflector array is configured to have the strongest lens action.

3. A charged particle-optical device according to claim 1 or 2, wherein the deflector array is configured to deflect the one or more charged particle beams within a respective field of view of the one or more charged particle beams.

4. A charged particle-optical device according to any preceding claim, wherein the one of the plurality of electrode plates adjacent the deflector array is further configured to comprise a beam limiting aperture array.

5. A charged particle-optical device according to any preceding claim wherein the plurality of electrode plates comprises an upbeam electrode plate and a downbeam electrode plate, wherein the upbeam electrode plate is configured to have the strongest lens action and the deflector array is located upbeam of the said upbeam electrode plate, and optionally wherein the charged particle-optical device further comprises a further deflector array located adjacent the downbeam electrode plate, the further deflector array configured to deflect one or more of the charged particle beams deflected by the deflector array so as to reduce an incident angle variation between the plurality of charged particle beams on the sample surface.

6. A charged particle-optical device according to any of claims 1 to 4, wherein the plurality of electrode plates comprises an upbeam electrode plate and a downbeam electrode plate, wherein the downbeam electrode plate is configured to have the strongest lens action and the deflector array is located downbeam of the downbeam electrode plate, and optionally wherein the charged particle-optical device further comprises a detector array facing the sample surface and wherein the deflector array is located between the said downbeam electrode and the detector array.

7. A charged particle-optical device according to claim 6 comprising a further deflector array located adjacent the upbeam electrode plate, the further deflector array configured to deflect one or more of the charged particle beams deflected by the deflector array so as to reduce an incident angle variation between the plurality of charged particle beams on the sample surface.

8. A charged particle-optical device according to any one of the preceding claims further comprising:

   an actuatable stage configured to support the sample and scan the sample in a first direction; and
   a scan deflector configured to scan the plurality of charged particle beams in a second direction substantially perpendicular to the first direction.

9. A charged particle-optical device according to claim 8 wherein the deflector array is configured to deflect one or more of the plurality of charged particle beams by a greater distance at the sample surface than the scan deflector.

10. A charged particle-optical device according to any one of the preceding claims further comprising an optical device configured to direct electromagnetic radiation to the sample location, wherein the deflector array is adjacent the optical device, and optionally wherein the deflector array is upbeam of the optical device.

11. A charged particle-optical device configured to direct a plurality of charged particle beams along respective beam paths towards a sample surface, the charged particle-optical device comprising an objective lens arrangement having:

   a one or more first electrode plates, each electrode plate having an array of first beam apertures, the array of first beam apertures of the respective first electrode plates being aligned with each other; and

a second electrode plate located adjacent one of the first electrode plates, wherein the second electrode plate has a plurality of second beam apertures and wherein at least one of the second beam apertures has a different alignment to the array of first beam apertures when compared to an alignment of the remainder of the plurality of second beam apertures to the array of the first beam apertures, so that at least one of plurality of charged particle beams has a different pitch with respect to its nearest neighbors.

12. A charged particle-optical device according to claims 11 , wherein the second electrode plate is configured to have the strongest lens action.

13. A charged particle-optical device according to any one of claims 11 or 12 further comprising:

an actuatable stage configured to support the sample and scan the sample in a first direction; and

a scan deflector configured to scan the plurality of charged particle beams in a second direction substantially perpendicular to the first direction, and optionally wherein the array of first beam apertures has an array pitch and the at least one of the second beam apertures is displaced from a corresponding one of the first beam apertures by a distance greater than the scanning range at the sample surface of the scan deflector.

14. A method of assessing a sample using an assessment apparatus comprising a charged particle-optical device configured to direct a plurality of charged particle beams onto the sample, the charged particle-optical device having a plurality of electron-optic electrodes; and a deflector array located adjacent the one of the plurality of electron-optic electrodes wherein the deflector array is configured to deflect one or more of the plurality of charged particle beams, the method comprising

energizing the deflector array to deflect one or more of the plurality of charged particle beams so that the at least one of the plurality of charged particle beams has a different pitch with respect to its nearest neighbors.

15. A field-replaceable electrode plate for an objective lens arrangement of a charged particle-optical device, wherein the field-replaceable electrode plate comprises a plurality of apertures and wherein at least one of the apertures has a different pitch with respect to its nearest neighbours.

# Fig. 1

# Fig. 2

# Fig. 3

# Fig. 4

## Fig. 5

# Fig. 6A

# Fig. 6B

# Fig. 7

# Fig. 8

# Fig. 9

# Fig. 10

# Fig. 11

Europäisches
Patentamt

European
Patent Office

Office européen
des brevets

# EUROPEAN SEARCH REPORT

**Application Number**

EP 24 20 4241

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2009/127658 A1 (MAPPER LITHOGRAPHY IP BV [NL]; WIELAND JAN JACO [NL] ET AL.) 22 October 2009 (2009-10-22) | 1,2,4-6 | INV. H01J37/147 H01J37/28 |
| Y | * paragraphs [0105], [0108]; figures 1, 2 * | 1-10 | H01J37/12 |
| Y | US 2023/005708 A1 (ZEIDLER DIRK [DE] ET AL) 5 January 2023 (2023-01-05) * paragraphs [0102], [0118] - [0125]; figures 1,3A-3G, 6 * | 1-10 | |
| Y | US 2021/343497 A1 (DE JAGER PIETER WILLEM HERMAN [NL]) 4 November 2021 (2021-11-04) * paragraphs [0060] - [0081]; claims 8,9; figures 9,10,13 * | 1-10 | |
| Y | EP 4 421 843 A1 (ASML NETHERLANDS BV [NL]) 28 August 2024 (2024-08-28) * paragraphs [0107] - [0133]; figures 11-14 * | 10 | |
| A | EP 4 117 014 A1 (ASML NETHERLANDS BV [NL]) 11 January 2023 (2023-01-11) * paragraphs [0105] - [0117]; figures 11-14 * | 10 | TECHNICAL FIELDS SEARCHED (IPC) H01J |

The present search report has been drawn up for all claims

| Place of search | Date of completion of the search | Examiner |
|---|---|---|
| The Hague | 17 March 2025 | Schmidt-Kärst, S |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

**Application Number**

**EP 24 20 4241**

---

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

---

## LACK OF UNITY OF INVENTION

The Search Division considers that the present European patent application does not comply with the requirements of unity of invention and relates to several inventions or groups of inventions, namely:

see sheet B

☐ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☒ None of the further search fees have been paid within the fixed time limit. The present European search report has been drawn up for those parts of the European patent application which relate to the invention first mentioned in the claims, namely claims:

1-10

☐ The present supplementary European search report has been drawn up for those parts of the European patent application which relate to the invention first mentioned in the claims (Rule 164 (1) EPC).

Europäisches
Patentamt

European
Patent Office

Office européen
des brevets

**LACK OF UNITY OF INVENTION**

**SHEET B**

Application Number

EP 24 20 4241

The Search Division considers that the present European patent application does not comply with the requirements of unity of invention and relates to several inventions or groups of inventions, namely:

1. claims: 1-10

   A charged particle-optical device configured to direct a plurality of charged particle beams along respective beam paths towards a sample surface, the charged particle-optical device comprising:
   - an objective lens arrangement having a plurality of electrode plates arranged to focus the plurality of charged particle beams onto the sample surface in a grid; and
   - a deflector array located adjacent one of the plurality of electrode plates,
   - wherein the deflector array is configured to deflect one or more of the plurality of charged particle beams so that in operation at least one of the plurality of charged particle beams spots on the sample has a pitch with respect to its nearest neighbours that is different from the pitch between the remaining beam spots.
   ---

2. claims: 11-15

   Electrode plate comprising a plurality of apertures and wherein at least one of the apertures has a pitch with respect to its nearest neighbours that is different from the pitch between the other apertures, as well as a charged particle-optical device comprising an objective lens comprising said electrode plate.
   ---

## ANNEX TO THE EUROPEAN SEARCH REPORT
## ON EUROPEAN PATENT APPLICATION NO.

EP 24 20 4241

This annex lists the patent family members relating to the patent documents cited in the above-mentioned European search report.
The members are as contained in the European Patent Office EDP file on
The European Patent Office is in no way liable for these particulars which are merely given for the purpose of information.

17-03-2025

| Patent document cited in search report | | Publication date | Patent family member(s) | | Publication date |
|---|---|---|---|---|---|
| WO 2009127658 | A1 | 22-10-2009 | AT | E535932 T1 | 15-12-2011 |
| | | | CN | 102067271 A | 18-05-2011 |
| | | | CN | 102067272 A | 18-05-2011 |
| | | | EP | 2279515 A1 | 02-02-2011 |
| | | | EP | 2281296 A2 | 09-02-2011 |
| | | | EP | 2402979 A2 | 04-01-2012 |
| | | | JP | 5268170 B2 | 21-08-2013 |
| | | | JP | 5384759 B2 | 08-01-2014 |
| | | | JP | 5475155 B2 | 16-04-2014 |
| | | | JP | 2011517130 A | 26-05-2011 |
| | | | JP | 2011517131 A | 26-05-2011 |
| | | | JP | 2013140997 A | 18-07-2013 |
| | | | JP | 2013140998 A | 18-07-2013 |
| | | | KR | 20110007199 A | 21-01-2011 |
| | | | KR | 20110015555 A | 16-02-2011 |
| | | | KR | 20150091417 A | 10-08-2015 |
| | | | KR | 20150099617 A | 31-08-2015 |
| | | | TW | 201003711 A | 16-01-2010 |
| | | | TW | 201003713 A | 16-01-2010 |
| | | | TW | 201515044 A | 16-04-2015 |
| | | | WO | 2009127658 A1 | 22-10-2009 |
| | | | WO | 2009127659 A2 | 22-10-2009 |
| US 2023005708 | A1 | 05-01-2023 | DE | 102021116969 B3 | 22-09-2022 |
| | | | NL | 2032349 A | 09-01-2023 |
| | | | TW | 202314765 A | 01-04-2023 |
| | | | US | 2023005708 A1 | 05-01-2023 |
| US 2021343497 | A1 | 04-11-2021 | EP | 3618095 A1 | 04-03-2020 |
| | | | TW | 202036150 A | 01-10-2020 |
| | | | US | 2021343497 A1 | 04-11-2021 |
| | | | WO | 2020043367 A1 | 05-03-2020 |
| EP 4421843 | A1 | 28-08-2024 | NONE | | |
| EP 4117014 | A1 | 11-01-2023 | NONE | | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2022101072 A1
- WO 2012165955 A
- WO 2021156121 A1
- WO 2021204734 A1
- EP 23211553
- WO 2021156121 A
- WO 2021204734 A
- WO 2004081910 A
- EP 3869535 A1
- WO 2021165136 A1
- WO 2022058252 A1
- US 2023109236 A1
- EP 2024055111 W